# EUROPÄISCHE PATENTANMELDUNG

(11) **EP 4 641 548 A1**
(43) Veröffentlichungstag der Anmeldung: **29.10.2025**
(21) Anmeldenummer: 25198371.4
(22) Anmeldetag: 05.11.2020
(51) Int. Cl.: G09F 3/20

(54) **REGALSCHIENE ZUR AUFNAHME EINER ELEKTRONISCHEN ANZEIGEVORRICHTUNG**

(62) Teilanmeldung aus: 20804190.5
(71) Anmelder: VusionGroup GmbH, 8072 Fernitz-Mellach (AT)
(72) Erfinder: Rössl, Andreas, 8072 Fernitz-Mellach (AT)
(74) Vertreter: Schneider, Michael

(57) **Zusammenfassung**

Regalschiene (1) zur Aufnahme von zumindest einer elektronischen Anzeigevorrichtung (2), insbesondere Produktinformation- und/oder Preisinformation-Anzeigevorrichtung, wobei die Regalschiene (1) aufweist: ein sich entlang der Regalschiene (1) erstreckendes erstes Klammerelement (15) und ein sich im Wesentlichen parallel dazu erstreckendes zweites Klammerelement (16), wobei die beiden Klammerelemente (15, 16) zum klammerartigen Zusammenwirken mit einer Befestigungsstruktur (17) der Anzeigevorrichtung (2) ausgebildet sind, wobei zumindest eines der beiden Klammerelemente (15, 16) derart ausgebildet ist, dass es eine Regalschiene-Aussteifungsstruktur bildet, die das Gehäuse bzw. die Gehäuseschale (6) einer bestimmungsgemäß in die Regalschiene (1) eingesetzten Anzeigevorrichtung (2) an ihrer Gehäuserückseite benachbart zu der Befestigungsstruktur (7), insbesondere im Wesentlichen bis hin zum Rand der Gehäuserückseite, aussteift.

## Beschreibung

### Technisches Feld

Die Erfindung betrifft eine Regalschiene, an der eine elektronische Anzeigevorrichtung befestigbar ist, sowie ein System, aufweisend die Regalschiene und die elektronische Anzeigevorrichtung.

### Hintergrund

Eine solche Regalschiene ist beispielsweise aus der PCT/EP2014/053376 bekannt.

In der Praxis hat sich herausgestellt, dass der Bildschirm bei unsachgemäßer Benutzung dazu tendiert, zu brechen oder Sprünge aufzuweisen. Insbesondere bei elektronischen Anzeigevorrichtungen (ESLs), deren Bildschirm-Abmessungen die Abmessung der gehäuserückseitigen Befestigungsstruktur, welche für die Befestigung an einer Regalschiene vorgesehen ist, überragen, wurde eine Bruchneigung festgestellt. Solche Beschädigungen des Bildschirms sind oft durch Unachtsamkeit von Kunden, die in einem Geschäft versehentlich mit einem Einkaufswagen gegen die an der Regalschiene befestigten ESLs fahren oder beim Entnehmen von Produkten mit diesen an die ESLs anstoßen, verursacht.

Die Erfindung hat sich vor diesem Hintergrund die Aufgabe gestellt, eine verbesserte Regalschiene bereitzustellen, sodass die erörterten Probleme vermieden werden.

### Zusammenfassung der Erfindung

Diese Aufgabe wird durch eine Regalschiene gemäß Anspruch 1 gelöst. Der Gegenstand der Erfindung ist daher eine Regalschiene zur Aufnahme von zumindest einer elektronischen Anzeigevorrichtung, insbesondere Produktinformation- und/oder Preisinformation-Anzeigevorrichtung, wobei die Anzeigevorrichtung einen Bildschirm und ein Gehäuse bzw. eine Gehäuseschale, in dem/der der Bildschirm aufgenommen ist, aufweist, wobei das Gehäuse bzw. die Gehäuseschale an seiner/ihrer den Bildschirm rückseitig umfassenden Gehäuserückseite eine Befestigungsstruktur aufweist, die derart ausgebildet ist, dass die Anzeigevorrichtung an der Regalschiene befestigbar ist, wobei die Regalschiene aufweist: ein sich entlang der Regalschiene erstreckendes erstes Klammerelement und ein sich im Wesentlichen parallel dazu erstreckendes zweites Klammerelement, wobei die beiden Klammerelemente die zum klammerartigen Zusammenwirken mit der Befestigungsstruktur der Anzeigevorrichtung ausgebildet sind, wobei zumindest eines der beiden Klammerelemente derart ausgebildet ist, dass es eine Regalschiene-Aussteifungsstruktur bildet, die das Gehäuse einer bestimmungsgemäß in die Regalschiene eingesetzten Anzeigevorrichtung an ihrer Gehäuserückseite benachbart zu der Befestigungsstruktur, insbesondere im Wesentlichen bis hin zum Rand der Gehäuserückseite, aussteift.

Die Erfindung betrifft weiters ein System, aufweisend die Regalschiene und die elektronische Anzeigevorrichtung.

Offenbart wird auch eine elektronische Anzeigevorrichtung, insbesondere Produktinformation- und/oder Preisinformation-Anzeigevorrichtung, die aufweist: einen Bildschirm, und ein Gehäuse bzw. eine Gehäuseschale, in dem/der der Bildschirm aufgenommen ist, und eine Anzeigevorrichtung-Aussteifungsstruktur, die zur Aussteifung der Anzeigevorrichtung gegenüber externer Krafteinwirkung ausgebildet ist.

Eine solche elektronische Anzeigevorrichtung weist einen Bildschirm auf, der üblicherweise als extrem energiesparender elektrophoretischer Bildschirm, auch bekannt unter dem Begrifft "Electronic Paper Display", kurz EPD, realisiert ist. Der Bildschirm wird in einem Gehäuse der Anzeigevorrichtung über Befestigungselemente gehalten, die dafür sorgen, dass der Bildschirm an seiner Sollposition im Gehäuse positioniert ist. Weiterhin ist in dem Gehäuse üblicherweise eine Elektronik untergebracht, welche den Bildschirm ansteuert, sodass auf dem Bildschirm z.B. Produktinformationen oder Preisinformationen zu Produkten angezeigt werden, die an die Elektronik von einem externen Steuergerät, beispielsweise einem Accesspoint im Laufe einer Funkkommunikation, übertragen werden. Der Accesspoint steht üblicherweise mit einem digitalen Warenwirtschafssystem bzw. dessen Server in Verbindung und erhält besagte Informationen von dort.

Mit den offenbarten Maßnahmen geht nun der Vorteil einher, dass zusätzlich zu dem Gehäuse bzw. der Gehäuseschale und der Befestigungsstruktur die Anzeigevorrichtung-Aussteifungsstruktur vorgesehen ist, welche die Anzeigevorrichtung gegenüber externer Krafteinwirkung aussteift, sodass es zu möglichst keiner Verformung des Bildschirms kommen kann und somit auch die Bruchneigung des Bildschirms bedingt durch die externe Kraftweinwirkung im Wesentlichen vollständig auszuschließen ist.

Analog verhält es sich mit der Regalschiene, welche sich in Blickrichtung auf die an der Regalschiene befestigte Anzeigevorrichtung hinter der Anzeigevorrichtung erstreckt und sie sozusagen als externe Aussteifungsstruktur gegenüber Krafteinwirkung von im Wesentlichen der Vorderseite her an der Rückseite der Anzeigevorrichtung aussteift. Da die Klammerelemente beiderseitig (in Bezug auf die Befestigungsstruktur der Anzeigevorrichtung) ausgebildet sind, kann damit auch die externe Aussteifungsstruktur beidseitig der Befestigungsstruktur vorliegen. Allerdings sind Anzeigevorrichtungen mitunter so an der Regalschiene befestigt, dass sie nach oben hin beinahe plan mit dem Regalboden verlaufen oder plan zu der vorderen aufragenden Kante des Regalbodens bzw. der Regalschiene abschließen. Dies hat vorwiegend ästhetische Gründe. Für die Anzeigevorrichtung bedeute dies jedoch, dass sie sich in Bezug auf die Befestigungsstruktur nach unten hin oft länger erstreckt als noch oben hin. So kann auch die durch die Regalschiene bereitgestellte externe Aussteifungsstruktur diesem Umstand Rechnung tragen und zur einen Seite der Befestigungsstruktur länger und zur anderen Seite der Befestigungsstruktur kürzer ausgebildet sein, um die Rückseite der Anzeigevorrichtung zu den beiden Seiten der Befestigungsstruktur möglichst vollflächig zu unterstützen bzw. auszusteifen. Dadurch wird die Wirkung von exzentrisch zu der Befestigungsstruktur auftretender Kräfte, die zu einem Biegemoment in der Struktur der Anzeigevorrichtung und somit auch im Bildschirm führen würden, abgefangen.

Weitere, besonders vorteilhafte Ausgestaltungen und Weiterbildungen der Erfindung ergeben sich aus den abhängigen Ansprüchen sowie der nachfolgenden Beschreibung.

Gemäß einem Aspekt der Offenbarung kann die Anzeigevorrichtung-Aussteifungsstruktur ein den Bildschirm von seiner bestimmungsgemäßen Betrachtungsseite her zumindest bereichsweise fassendes Vorderseite-Aussteifungselement aufweisen.

Dieses Vorderseite-Aussteifungselement kann beispielsweise als Rahmen ausgebildet sein und den Bildschirm rahmenförmig fassen.
Der Rahmen kann beispielsweise aus einem formstabilen Kunststoff, wie beispielsweise Acrylnitril-Butadien-Styrol-Copolymer (kurz ABS) gefertigt sein. Auch kann der Rahmen aus einem Verbundwerkstoff wie beispielsweise durch einen kohlenstofffaserverstärkten Kunststoff realisiert sein.

Der Rahmen kann grundsätzlich ohne Sichtscheibe und ähnliches vorliegen, um die beste Lesbarkeit des Bildschirminhaltes zu gewährleisten. Um jedoch eine erhöhte Aussteifung zu erzielen, kann es von Vorteil sein, wenn der Rahmen eine Sichtscheibe aufweist.

In diesem Kontext kann die Sichtscheibe beispielsweise aus einem transparenten Kunststoff wie Polymethylmethacrylat (PMMA) bestehen, sodass die Sichtscheibe höchste Stoß- und Kratzfestigkeit aufweist. Ebenso kann die Sichtscheibe aus einem Polycarbonat bestehen.

Der Rahmen und die Sichtscheibe können aus unterschiedlichen Materialen oder auch aus dem gleichen Material gefertigt sein und können auch als ein Stück oder als separate Stücke vorliegen.

Gemäß einem weiteren Aspekt der Offenbarung kann die Anzeigevorrichtung-Aussteifungsstruktur ein den Bildschirm an seiner von der bestimmungsgemäßen Betrachtungsseite abgewandten Rückseite direkt fassendes Rückseite-Aussteifungselement aufweisen.

Diese Rückseite-Aussteifungselement kann z.B. rippenartig realisiert sein. Bevorzugt ist das Rückseite-Aussteifungselement als Platte ausgebildet und mit der Rückseite des Bildschirms materialschlüssig verbunden, insbesondere an die Rückseite geklebt bzw. laminiert. Dadurch wird der Querschnitt des Bildschirms de facto "erhöht", er wird also dicker und das Widerstandsmoment wird erhöht, wodurch der Bildschirm selbst ausgesteift wird.

Die Platte kann als eine Mehrlagenstruktur, bevorzugt als Sandwichstruktur, realisiert sein. Darunter können verschiedenste Verbundwerkstoffe verstanden werden, deren Lagen entweder eben und/oder räumliche strukturiert miteinander verbunden sind.

Gemäß einem weiteren Aspekt der Offenbarung kann die Anzeigevorrichtung-Aussteifungsstruktur ein Raumfüllung-Aussteifungselement aufweisen, das einen, insbesondere hinter dem Bildschirm, liegenden Innenraum des Gehäuses zumindest bereichsweise versteifend ausfüllt. Damit geht der Vorteil einher, dass jene Innenraumbereiche des Gehäuses, die bei bekannten Anzeigevorrichtungen aus Gründen der Materialeinsparung üblicherweise leer sind, im Kontext der vorliegenden Offenbarung für die Zwecke der Aussteifung genutzt werden. Diese Maßnahme hat sich insbesondere deshalb als vorteilhaft erwiesen, weil der Trend bei modernen elektronischen Anzeigevorrichtungen zu immer größeren Bildschirmen geht. Da jedoch der Raumbedarf für eine gegebenenfalls vorzusehende Batterie und die eingangs erwähnte Elektronik nicht mit der Größe des Bildschirms skaliert, wächst auch jener Innenraum des Gehäuses, der sich hinter dem Bildschirm befindet. Ohne Raumfüllung-Aussteifungselement kann das Gehäuse einer herkömmlichen Anzeigevorrichtung der externen Krafteinwirkung nicht soweit entgegenwirken, dass die Bruchneigung des Bildschirms zuverlässig vermieden werden kann. Dies kann erst durch das raumnutzende Vorsehen des Raumfüllung-Aussteifungselements erzielt werden.

Trotz raumfüllender Ausmaße kann auch hier eine möglichst materialsparende Variante von Vorteil sein. So kann das Raumfüllung-Aussteifungselement durch zumindest eine Raumstruktur der nachfolgend angeführten Gruppe realisiert sein, nämlich:
- eine wabenförmige Raumstruktur, insbesondere eine honigwabenförmige Raumstruktur,
- eine rippenförmige Raumstruktur,
- eine wellenförmige Raumstruktur,
- eine säulenförmige Raumstruktur,
- eine spiralförmige Raumstruktur.

Hierunter sind insbesondere Strukturen mit länglichen Grundflächen zu verstehen. Der Querschnitt der Grundflächen kann sich mit der Höhe der Struktur verändern. So kann der Querschnitt in eine Richtung hin schmäler werden, sodass eine Fertigung mittels Spritzguss leichter möglich ist.

Unter einer rippenförmigen Raumstruktur ist eine Struktur zu verstehen, bei der Materialbahnen beispielsweise gerade oder gekrümmt verlaufen. Diese Materialbahnen können parallel zueinander verlaufen. Die Raumstruktur kann aus mehreren Materialbahnen bestehen, die vollflächig oder teilflächig ausgebildet sind. Diese Materialbahnen können sich beispielsweise auch kreuzen, sodass die materialfreien dazwischenliegenden Räume Prismen bilden. Die Materialbahnen müssen jedoch nicht gerade verlaufen, vielmehr sind auch andere Verläufe möglich. So können die Materialbahnen auch wellenförmig oder spiralförmig sein. Auch diese Materialbahnen können sich kreuzen. Es sind jedoch auch nicht bandförmige Raumstrukturen möglich. So kann das Raumfüllung-Aussteifungselement beispielsweise durch mehrere Säulen realisiert sein. Diese Säulen können einen einer Kurve folgenden, bevorzugt runden, Querschnitt oder auch einen eckigen Querschnitt aufweisen. Sie können ohne Berührungspunkte miteinander existieren oder auch Kreuzungspunkte aufweisen. Als besonders vorteilhaft haben sich jedoch wabenartige, insbesondere Bienenwaben-Strukturen herausgestellt, insbesondere dann, wenn sich Ihr Hohlraum zwischen der Innenseite des Gehäuses bzw. der Gehäuseschale und dem Bildschirm bzw. dessen Rückseite, die ggf. mit dem Rückseite-Aussteifungselement bedeckt ist, erstreckt. Auch können unterschiedliche Raumstrukturen kombiniert werden.

Als besonders vorteilhaft hat es sich erwiesen, wenn das Raumfüllung-Aussteifungselement zumindest bereichsweise hinter dem Bildschirm, insbesondere benachbart zu einer hinter dem Bildschirm vorgesehenen Elektronik bzw. einem Elektronikmodul, angeordnet ist und den Bildschirm an seiner Rückseite zum Gehäuse hin unterstützt. Dort steift es das Gehäuse an jener Stelle aus, wo üblicherweise ein Hohlraum hinter dem Bildschirm wäre. Somit können Kräfte, die z.B. flach von außen auf den Bildschirm bzw. jene den Bildschirm nach außen hin schützende Lage(n), wie z.B. ein Sichtfenster, ein Kratzschutz, usw., einwirken aufgenommen werden, und zwar ohne, dass es zu einer bruchverursachenden Verbiegung des Bildschirm kommt. Dabei handelt es ich im Wesentlichen um eine Unterstützung des Bildschirms an seiner Rückseite, um Normalkräfte auf den Bildschirm abzufangen. Allerdings kann das Raumfüllung-Aussteifungselement auch so in das Gehäuse bzw. die Gehäuseschale eingebaut bzw. integriert sein, dass es gegen andere Kräfte aussteift, die bei Einwirkung auf die Anzeigevorrichtung zu einer bruchverursachenden Krümmung bzw. allgemein Verformung des Bildschirms führen würden. Zu diesem Zweck muss das Raumfüllung-Aussteifungselement so in das Gehäuse integriert sein, dass es eine andernfalls unter Krafteinwirkung auf das Gehäuse zu erwartende, insbesondere kritische, Verkrümmung des Gehäuses, die letztendlich auch zu einer kritischen Verkrümmung des Bildschirms und somit zu einem Bildschirmbruch führen würde, verhindert. Das Raumfüllung-Aussteifungselement muss daher so mit den Wänden z.B. hinter dem Bildschirm angeordnet mit den Seitenwänden wie auch mit der Rückwand des Gehäuses der Anzeigevorrichtung zusammenwirken, dass es unter Krafteinwirkung von außen auf die Anzeigevorrichtung den Innenraum der Anzeigevorrichtung so aussteift, dass besagte Verkrümmung gar nicht oder nur im akzeptablen Grad minimal eintreten kann.

Vor diesem Hintergrund hat es sich als besonders vorteilhaft erwiesen, dass das Raumfüllung-Aussteifungselement als Bestandteil des Gehäuses ausgebildet ist. Diese Ausbildung erlaubt es auch, das Raumfüllung-Aussteifungselement in einem Arbeitsgang zusammen mit zumindest einem Teil des Gehäuses zu realisieren. Dies kann z.B. im Zuge der Herstellung der hinteren Gehäuseseite bzw. Gehäuseschale im Spritzgussverfahren geschehen. Dabei werden im Wesentlichen die Rückwand, die Seitenwände, die internen Befestigungselemente für Elektronik und Bildschirm zusammen mit dem Raumfüllung-Aussteifungselement in einem Arbeitsschritt erzeugt. Damit ergibt sich eine einteilige Ausbildung mit diesem Gehäuseteil, was eine optimale Kraftübertragung von außen auf das Gehäuse einwirkenden Kräften auf das Raumfüllung-Aussteifungselement mit sich bringt. Das Raumfüllung-Aussteifungselement kann derart realisiert das Gehäuse bzw. die Gehäuseschale optimal, insbesondere mit geringem Materialaufwand, aussteifen.

Bei der einteiligen Ausbildung kann es auch von Vorteil sein, wenn der verbleibende Raum bzw. der durch das Raumfüllung-Aussteifungselement strukturierte Raum mit einem Kunststoff, wie z.B. Epoxidharz, ausgefüllt wird, um die aussteifende Wirkung zu erhöhen.

Auch kann vorgesehen sein, dass das nicht einteilig mit dem Gehäuseteil bzw. der Gehäuseschale ausgebildete Raumfüllung-Aussteifungselement in einen aushärtbaren Kunststoff, wie z.B. Epoxidharz oder dergleichen, der in den auszufüllenden Raum des Gehäuseteils bzw. der Gehäuseschale eingebracht wird, eingesetzt wird, und nach dem Aushärten des Kunststoffs besagte, die Aussteifung verbessernde Verbindung des Raumfüllung-Aussteifungselements mit dem Gehäuseteil bzw. der Gehäuseschale hergestellt ist. Ebenso kann nach dem Einsetzen des Raumfüllung-Aussteifungselement der verbleibende Raum bzw. der durch das Raumfüllung-Aussteifungselement strukturierte Raum mit besagtem Kunststoff ausgegossen bzw. gefüllt werden.

Ebenso kann das gesamte Raumfüllung-Aussteifungselement durch besagten Kunststoff selbst gebildet sein, der dann den zur Verfügung stehenden Raum zumindest so weit ausfüllt, dass die nötige aussteifende Wirkung erhalten ist, oder ggf. den zur Verfügung stehenden Raum möglichst vollständig ausfüllt, um eine maximale Aussteifung zu erhalten.

Auch kann das Gehäuse an seiner den Bildschirm rückseitig umfassenden Gehäuserückseite eine Befestigungsstruktur aufweisen, die derart ausgebildet ist, dass die Anzeigevorrichtung an einer Regalschiene befestigbar ist. Diese Befestigungsstruktur kann beispielsweise flach an der Gehäuserückseite ausgebildet sein. Bevorzugt erhebt sie sich jedoch hin zu der Regalschiene, um dort z.B. schienenartig und/oder klammerartig mit dieser zusammenzuwirken. Dies bewirk, dass auch die Befestigungsstruktur als solches eine aussteifende Wirkung hat, wodurch es im Wesentlichen ausreichen kann, dass das Raumfüllung-Aussteifungselement benachbart dazu positioniert ist und somit jene Bereiche des Gehäuses aussteift, die nicht durch die Befestigungsstruktur ausgesteift sind.

Die Befestigungsstruktur muss jedoch nicht in sich geschlossen oder gekapselt vorliegen. So kann zumindest ein Teil der Befestigungsstruktur als Batteriefachabdeckung ausgebildet sein. Innerhalb der Befestigungsstruktur können in diesem Fall Batterien aufgenommen sein, die für die elektrische Versorgung der Elektronik bzw. des Elektronikmoduls sowie des Bildschirms zur Anwendung kommen. Somit lässt sich die Befestigungsstruktur dreifach nützen, nämlich erstens zur Befestigung der Anzeigevorrichtung an der Regalschiene, zweitens zum Aussteifen des Gehäuses in ihrem Bereich und drittens zum Aufnehmen der Batterien.

In Bezug auf die Regalschiene kann gemäß einem weiteren Aspekt der Erfindung zumindest eines der beiden Klammerelemente der Regalschiene einen Betätigungsfortsatz aufweisen, der so dimensioniert ist, dass er über den Gehäuserand des Gehäuses einer bestimmungsgemäß in die Regalschiene eingesetzten Anzeigevorrichtung hinausragt, wobei das den Betätigungsfortsatz aufweisende Klammerelement derart ausgebildet ist, dass bei einer Krafteinwirkung auf den Betätigungsfortsatz das klammerartige Zusammenwirken mit der Befestigungsstruktur der Anzeigevorrichtung lösbar ist. Bevorzugt ist dieser Betätigungsfortsatz entlang der gesamten Regalschiene ausgebildet. Der Betätigungsfortsatz kann an beiden Klammerelementen ausgebildet sein. Besonders bevorzugt ist der Betätigungsfortsatz an jenem Klammerelement ausgebildet, das die längere externe Aussteifungsstruktur bildet. Damit geht der Vorteil einher, dass bei entsprechender Ankopplung des betreffenden Klammerelements an die Regalschiene ein langer Hebelarm für die Betätigung gebildet ist, der ein leichtes Öffnen der Klammerwirkung erlaubt.

Gemäß einem weiteren Aspekt weist zumindest eines der Klammerelemente ein zum Zusammenwirken mit der Befestigungsstruktur der Anzeigevorrichtung bestimmtes Fixierung-Element zur Fixierung der Position der Anzeigevorrichtung, bevorzugt ausgebildet als Kunststoffelement, besonders bevorzugt realisiert als auf das Klammerelement extrudierte Kunststoffbahn, auf. Dieses Fixierung-Element stellt sicher, dass bei geklammerter Befestigungsstruktur kein seitliches Verrutschen der Anzeigevorrichtung (unter üblicher manueller Krafteinwirkung oder auch unbeabsichtigtem Anstoßen an die Anzeigevorrichtung z.B. mit einem Einkaufswagen oder einem Produkt) auftreten kann. Es wird also die Position der Anzeigevorrichtung entlang der Regalschiene durch Reibung fixiert, wobei natürlich bei gelöster Klammerwirkung (also wenn der Betätigungsfortsatz betätigt ist) eine wahlfreie Positionierung der Anzeigevorrichtung entlang der Regalschiene erhalten bleibt.

Diese und weitere Aspekte der Erfindung ergeben sich durch die nachfolgend erörterten Figuren.

### Figurenkurzbeschreibung

Die Erfindung wird im Folgenden unter Hinweis auf die beigefügten Figuren anhand von Ausführungsbeispielen noch einmal näher erläutert, auf welche die Erfindung jedoch nicht beschränkt ist. Dabei sind in den verschiedenen Figuren gleiche Komponenten mit identischen Bezugszeichen versehen. Es zeigen auf schematische Weise:
- Fig. 1: eine an einer Regalschiene befestigte Anzeigevorrichtung;
- Fig. 2: die Anzeigevorrichtung in einer Explosionsdarstellung;
- Fig. 3: einen Querschnitt durch die Regalschiene benachbart zu der Anzeigevorrichtung;
- Fig. 4: ein Detail des unteren Endes der Regalschiene.

### Beschreibung der Ausführungsbeispiele

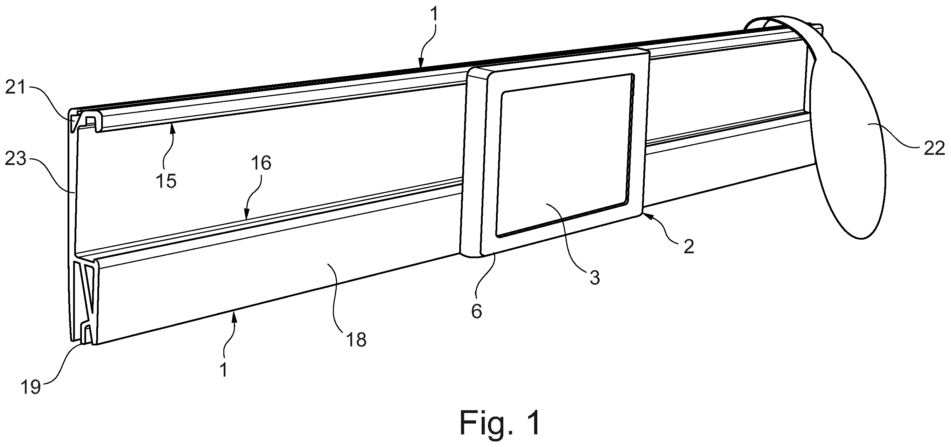

In der Figur 1 ist eine an einer Regalschiene 1 befestigte elektronische Anzeigevorrichtung 2, im Fachjargon als Electronic Shelf Label (ESL) bezeichnet und nachfolgend als ESL 2 angeführt, dargestellt.

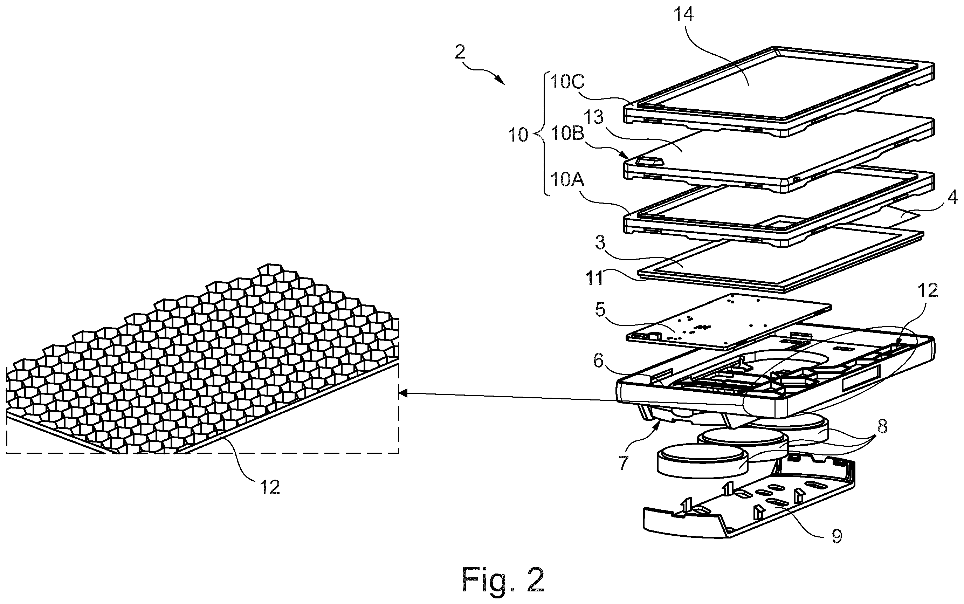

Details des ESLs 2 sind in der Figur 2 in Form einer Explosionsdarstellung sichtbar. Das ESL 2 weist einen Bildschirm 3 auf. Der Bildschirm 3 ist als Electronic Paper Display (EPD) realisiert und weist daher seinen eigenen EPD-Controller (nicht dargestellt) auf. Über ein Flachbandkabel 4 ist der Bildschirm 3 mit einer Elektronik 5 des ESLs 2 verbunden. Diese Elektronik 5 führt die Funk-Kommunikation mit einem Access-Point (nicht dargestellt) aus, über den Daten, welche Produkt- und/oder Preisinformationen betreffen, an das ESL 2 zur Visulisierung mit dem Bildschirm 3 übermittelt werden. Details zum hier zur Anwendung kommenden elektronischen Aufbau und zum Funkverkehr bzw. Funkprotokoll sowie dem gesamten System sind beispielsweise in der PCT/EP2014/053376 offenbart.

Das ESL 2 weist weiterhin eine den Bildschirm 3 von seiner Rückseite her umfassende hintere Gehäuseschale 6 auf, die aus einem Kunststoff im Spritzgussverfahren hergestellt ist. In die Gehäuseschale 6 wird zunächst die Elektron 5 an eine dafür vorgesehene Aufnahmezone eingesetzt, die Elektronik 5 über das Flachbandkable 4 mit dem Bildschirm 3 verbunden und der Bildschirm 3 über die Elektronik 4 in die Gehäuseschale 6 eingelegt.

An der Rückseite der Gehäuseschale 6 ist eine Befestigungsstruktur 7 zur Befestigung des ESLs 2 an der Regalschiene 1 ausgebildet. In ihrem Inneren ist die Befestigungsstruktur 7 zur Aufnahme von drei Batterien 8 als Batterielade ausgebildet. Die Elektronik 5 kontaktiert die eingesetzten Batterien 8 über in dieser Perspektive nicht sichtbare Kontaktelemente, so dass die Batterien 8 alle elektronischen Komponenten des ESLs 2 mit Energie versorgen können. Die mit Hilfe der Befestigungsstruktur 7 gebildete Batterielade wird mit einem Batterieladen-Deckel 9 verschlossen.

Das ESLs 2 weist zur Aussteifung eine Anzeigevorrichtung-Aussteifungsstruktur auf, die wie folgt realisiert ist.

Die Anzeigevorrichtung-Aussteifungsstruktur weist zunächst ein Vorderseite-Aussteifungselement 10 auf, das durch eine der drei Ausbildungsformen, welche aus Gründen der Übersichtlichkeit übereinander in der Figur 2 dargestellt sind, ausgebildet sein kann. So kann beispielsweise das Vorderseite-Aussteifungselement 10 durch einen stabilen Rahmen 10A gebildet sein, der keine Sichtscheibe aufweist. Weiterhin kann das Vorderseite-Aussteifungselement 10 durch einen stabilen, ggf. auch transparenten) Rahmen 10B mit einer Sichtschiebe 13 realisiert sein. Weiterhin kann das Vorderseite-Aussteifungselement 10 durch einen stabilen Rahmen 10C mit einer hoch-festen Sichtscheibe 14 realisiert sein.

Die Anzeigevorrichtung-Aussteifungsstruktur weist weiterhin als ein Rückseite-Aussteifungselement 11 eine Platte auf, die in Sandwich-Bauweise vorliegt und die den Bildschirm 3 vollflächig an seiner Rückseite abdeckend und direkt auf die Rückseite des Bildschirms 3 laminiert bzw. geklebt ist.

Die Anzeigevorrichtung-Aussteifungsstruktur weist weiterhin ein Raumfüllung-Aussteifungselement 12 auf, das einteilig mit der Gehäuseschale 6 ausgebildet ist, also ein Bestandteil des Gehäuses des ESL 2 ist. Das Raumfüllung-Aussteifungselement 12 ist honigwabenförmig strukturiert und füllt den Innenraum der Gehäuseschale 7 aus, der benachbart zu der Elektronik 5 bzw. zu der Befestigungsstruktur 7 hinter dem Bildschirm 3 liegt. Die Honigwabenstruktur ist in der Vergrößerung des Raumfüllung-Aussteifungselements 12 gut sichtbar.

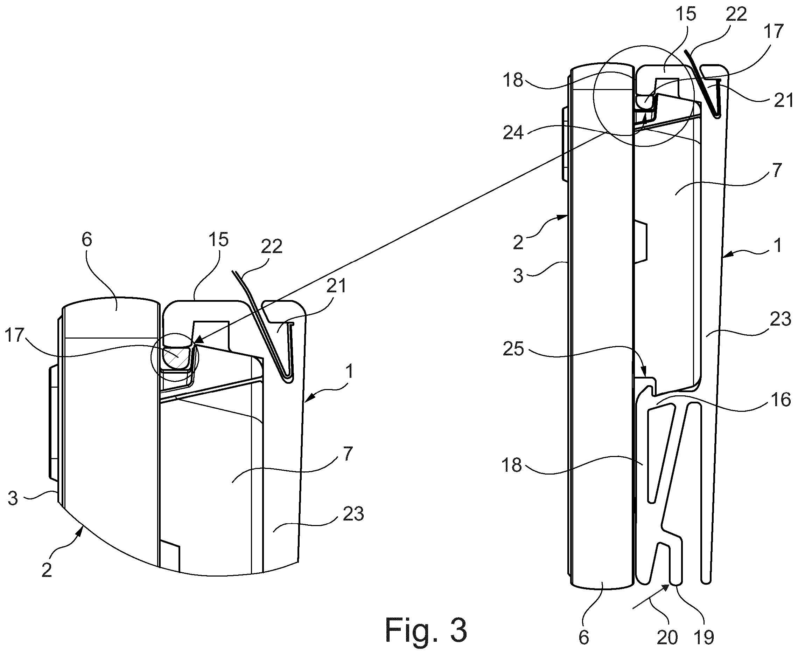

Nachfolgend ist auf die Figur 3 verwiesen. Hier ist ein Querschnitt durch die Regalschiene 1 mit in die Regalschiene 1 eingesetztem ESL 2 zu sehen. Die Regalschiene 1 weist ein erstes (oberes) Klammerelement 15 und ein zweites (unteres) Klammerelement 16 auf, zwischen denen die Befestigungsstruktur 7 des ESLs 2 eingeklammert ist. Dabei greift das erste Klammerelemente 15 in einen oberen Kanal 24 und das zweite Klammerelement 17 in einen unteren Kanal 25 ein (siehe dazu Figur 1). Die Kanäle 24 und 25 sind zwischen der ebenen Fläche der Rückwand der Gehäuseschale 7 und einem daran anschließenden abgesetzten Bereich der Befestigungsstruktur 7 ausgebildet. Deutlich zu sehen ist in der Vergrößerung des oberen Bereichs des klammerartigen Zusammenwirkens der Befestigungsstruktur 7 des ESLs 2 mit dem ersten Klammerelement 15, dass an dem äußersten Ende des ersten Klammerelements 15 eine Kunststoffbahn 17 (ggf. ein Gummibelag) ausgebildet ist, die gegen die Befestigungsstruktur gepresst wird und so ein Verrutschen des ESLs 2 in der Regalschiene verhindert. Sie bildet ein Fixierungs-Element der Regalschiene 1.

Das erste (obere) Klammerelement 15 wie auch das zweite (unterer) Klammerelement 16 weisen parallel zur Rückseite der Gehäuseschale 7 verlaufende Abschnitte auf, welche die (oberer bzw. unterer) Regalschiene-Aussteifungsstrukturen 18 bilden und mit der Gehäuseschale 6 in Kontakt stehen können und somit auch zur Aussteifung des ESLs 2 beitragen.

Kopfseitig weist die Regalschiene 1 einen Kanal 21 auf, der zum Einschnappen bzw. Einlegen eines papier- und/oder kunststoffbasierten Etiketts 22 ausgebildet ist, so wie dies in den Figuren 1 und 3 sichtbar ist.

Die Regalschiene 1 weist weiterhin einen Betätigungsfortsatz 19 auf, der manuell betätigbar ist und bei seiner Betätigung in Richtung des Pfeils 20 die klammernde Wirkung zwischen dem zweiten Klammerelement 16 und der Befestigungsstruktur 7 löst. Er ist im Abstand von der im Wesentlichen eng an die Gehäuseschale 6 anliegenden (unteren) Regalschiene-Aussteifungsstruktur 18 positioniert, um zielgerichtet betätigt zu werden.

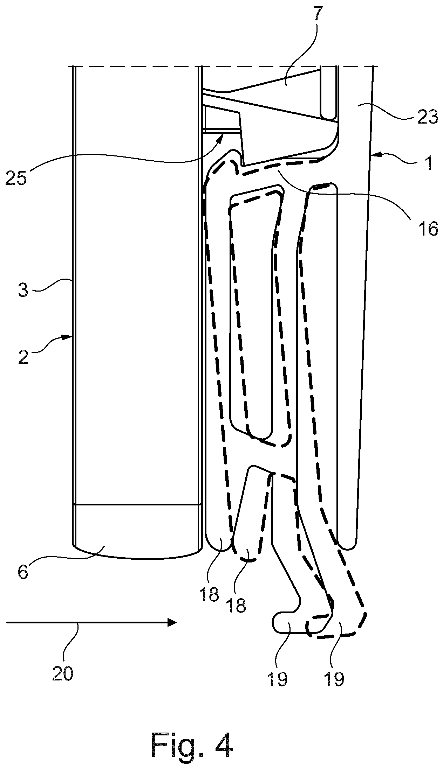

Hierzu ist in der Figur 4, die einen Ausschnitt im Bereich des zweiten Klammerelements 16 zeigt, eine weitere Ausbildungsform visualisiert, die ein noch einfacheres Betätigen des Betätigungsfortsatz 19 erlaubt, weil dieser über den unteren Rand des ESLs 2 hinausragt. Auch ist hier schematisch die Bewegung des zweiten Klammerelements 16 unter Betätigung in Richtung des Pfeils 20 zu sehen. Dabei handelt es sich um eine elastische Verformung des Ansatzes des zweiten Klammerelements 16 der Regalschiene 1. Die (untere) Regalschiene-Aussteifungsstruktur 18 ist hierfür so ausgebildet bzw. geformt, dass sie bei Betätigung des Betätigungsfortsatzes 19 einerseits das zweite Klammerelement 16 vom ersten Klammerelement 15 wegbewegt und somit die Klemmung löst und andererseits bedingt durch seine Schwenkbewegung das ESLs 2 in Richtung der betätigenden Person leicht aus der Regalschiene 1 heraus drückt. Das ESLs 2 wird so bei der Betätigung des Betätigungsfortsatzes 19 gelöst und etwas nach vorne (hin zur betätigenden Hand) geneigt, was eine einfachere Entnahme des ESLs 2 ermöglicht.

Abschließend sei noch erwähnt, dass beim Zusammenbau des ESLs 2 die Gehäuseschale 6 mit dem jeweiligen Vorderseite-Aussteifungselement 10A, 10B oder 10C zusammengefügt wird. Dies kann durch einfaches formschlüssiges Zusammenstecken, durch verschrauben, durch verkleben oder auch durch verschweißen geschehen, wodurch ein geschlossenes Gehäuse erhalten ist. Für den Fall, dass das Vorderseite-Aussteifungselement 10A, also der Rahmen ohne Sichtscheibe, zum Einsatz kommt, bildet auch der Bildschirm 3 selbst innerhalb des durch den Rahmen gebildeten Bereiches einen Bestandteil des Gehäuses.

Es wird abschließend noch einmal darauf hingewiesen, dass es sich bei den vorangehend detailliert beschriebenen Figuren nur um Ausführungsbeispiele handelt, welche vom Fachmann in verschiedenster Weise modifiziert werden können, ohne den Bereich der Erfindung zu verlassen. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können.
Offenbart werden auch die folgenden Ausführungsformen.
Ausführungsform 1. Elektronische Anzeigevorrichtung (2), insbesondere Produktinformation- und/oder Preisinformation-Anzeigevorrichtung, die aufweist:
   - einen Bildschirm (2), und
   - ein Gehäuse bzw. eine Gehäuseschale (6), in dem/der der Bildschirm aufgenommen ist, und
   - eine Anzeigevorrichtung-Aussteifungsstruktur, die zur Aussteifung der Anzeigevorrichtung gegenüber externer Krafteinwirkung ausgebildet ist.
Ausführungsform 2. Anzeigevorrichtung (2) nach Ausführungsform 1, wobei die Anzeigevorrichtung-Aussteifungsstruktur ein den Bildschirm (2) von seiner bestimmungsgemäßen Betrachtungsseite her zumindest bereichsweise fassendes Vorderseite-Aussteifungselement (10A; 10B; 10C) aufweist.
Ausführungsform 3. Anzeigevorrichtung (2) nach Ausführungsform 2, wobei das Vorderseite-Aussteifungselement (10A; 10B; 10C) als Rahmen ausgebildet ist und den Bildschirm (3) rahmenförmig fasst.
Ausführungsform 4. Anzeigevorrichtung (2) nach Ausführungsform 3, wobei der Rahmen eine Sichtscheibe (13; 14) aufweist.
Ausführungsform 5. Anzeigevorrichtung (2) nach einer der Ausführungsformen 1 bis 4, wobei die Anzeigevorrichtung-Aussteifungsstruktur ein den Bildschirm (3) an seiner von der bestimmungsgemäßen Betrachtungsseite abgewandten Rückseite direkt fassendes Rückseite-Aussteifungselement aufweist.
Ausführungsform 6. Anzeigevorrichtung (2) nach Ausführungsform 5, wobei das Rückseite-Aussteifungselement als Platte (11) ausgebildet ist und mit der Rückseite des Bildschirms (3) materialschlüssig verbunden ist, insbesondere an die Rückseite laminiert ist.
Ausführungsform 7. Anzeigevorrichtung (2) nach Ausführungsform 6, wobei die Platte (11) als Mehrlagenstruktur, bevorzugt als Sandwichstruktur, realisiert ist.
Ausführungsform 8. Anzeigevorrichtung (2) nach einer der vorangehenden Ausführungsformen, wobei die Anzeigevorrichtung-Aussteifungsstruktur ein Raumfüllung-Aussteifungselement aufweist, das einen, insbesondere hinter dem Bildschirm (3), liegenden Innenraum des Gehäuses bzw. der Gehäuseschale (6) zumindest bereichsweise versteifend ausfüllt.
Ausführungsform 9. Anzeigevorrichtung (2) nach Ausführungsform 8, wobei das Raumfüllung-Aussteifungselement (12) durch zumindest eine Raumstruktur der nachfolgend angeführten Gruppe realisiert ist, nämlich:
   - eine wabenförmige Raumstruktur, insbesondere eine honigwabenförmige Raumstruktur,
   - eine rippenförmige Raumstruktur,
   - eine wellenförmige Raumstruktur,
   - eine säulenförmige Raumstruktur,
   - eine spiralförmige Raumstruktur.
Ausführungsform 10. Anzeigevorrichtung (2) nach einer der Ausführungsformen 8 bis 9, wobei das Raumfüllung-Aussteifungselement (12) zumindest bereichsweise hinter dem Bildschirm (3), insbesondere benachbart zu einer hinter dem Bildschirm (3) vorgesehenen Elektronik (5), angeordnet ist und den Bildschirm (3) an seiner Rückseite zum Gehäuse bzw. zur Gehäuseschale (6) hin unterstützt.
Ausführungsform 11. Anzeigevorrichtung (2) nach einer der Ausführungsformen 8 bis 10, wobei das Raumfüllung-Aussteifungselement (12) als Bestandteil des Gehäuses bzw. der Gehäuseschale (6) ausgebildet ist.
Ausführungsform 12. Anzeigevorrichtung (2) nach einer der vorangehenden Ausführungsformen, wobei das Gehäuse bzw. die Gehäuseschale (6) an seiner den Bildschirm (3) rückseitig umfassenden Gehäuserückseite eine Befestigungsstruktur (7) aufweist, die derart ausgebildet ist, dass die Anzeigevorrichtung (2) an einer Regalschiene (1) befestigbar ist.
Ausführungsform 13. Anzeigevorrichtung (2) nach Ausführungsform 12, wobei zumindest ein Teil der Befestigungsstruktur (7) als Batteriefachabdeckung (9) ausgebildet ist.
Ausführungsform 14. Regalschiene (1) zur Aufnahme von zumindest einer elektronischen Anzeigevorrichtung (2), insbesondere Produktinformation- und/oder Preisinformation-Anzeigevorrichtung, wobei die Anzeigevorrichtung (2) einen Bildschirm (3) und ein Gehäuse bzw. eine Gehäuseschale (6), in dem/der der Bildschirm (3) aufgenommen ist, aufweist, wobei das Gehäuse bzw. die Gehäuseschale (6) an seiner/ihrer den Bildschirm (3) rückseitig umfassenden Gehäuserückseite eine Befestigungsstruktur (7) aufweist, die derart ausgebildet ist, dass die Anzeigevorrichtung (2) an der Regalschiene (1) befestigbar ist,
   wobei die Regalschiene (1) aufweist:
   ein sich entlang der Regalschiene (1) erstreckendes erstes Klammerelement (15) und ein sich im Wesentlichen parallel dazu erstreckendes zweites Klammerelement (16), wobei die beiden Klammerelemente (15, 16) zum klammerartigen Zusammenwirken mit der Befestigungsstruktur (17) der Anzeigevorrichtung (2) ausgebildet sind, wobei zumindest eines der beiden Klammerelemente (15, 16) derart ausgebildet ist, dass es eine Regalschiene-Aussteifungsstruktur bildet, die das Gehäuse bzw. die Gehäuseschale (6) einer bestimmungsgemäß in die Regalschiene (1) eingesetzten Anzeigevorrichtung (2) an ihrer Gehäuserückseite benachbart zu der Befestigungsstruktur (7), insbesondere im Wesentlichen bis hin zum Rand der Gehäuserückseite, aussteift.
Ausführungsform 15. Regalschiene (1) nach Ausführungsform 14, wobei zumindest eines der beiden Klammerelemente (15, 16) einen Betätigungsfortsatz (19) aufweist, der so dimensioniert ist, dass er über den Gehäuserand des Gehäuses bzw. der Gehäuseschale (6) einer bestimmungsgemäß in die Regalschiene (1) eingesetzten Anzeigevorrichtung (2) hinausragt, wobei das den Betätigungsfortsatz (19) aufweisende Klammerelement(16) derart ausgebildet ist, dass bei einer Krafteinwirkung auf den Betätigungsfortsatz (19) das klammerartige Zusammenwirken mit der Befestigungsstruktur (7) der Anzeigevorrichtung (2) lösbar ist.
Ausführungsform 16. Regalschiene (1) nach einer der vorangehenden Ausführungsformen 14 bis 15, wobei zumindest eines der Klammerelemente (15, 16) ein zum Zusammenwirken mit der Befestigungsstruktur (7) der Anzeigevorrichtung (2) bestimmtes Fixierung-Element (17) zur Fixierung der Position der Anzeigevorrichtung (2), bevorzugt ausgebildet als Kunststoffelement, besonders bevorzugt realisiert als auf das Klammerelement (15) extrudierte Kunststoffbahn, aufweist.

## Patentansprüche

1. Regalschiene (1) zur Aufnahme von zumindest einer elektronischen Anzeigevorrichtung (2), insbesondere Produktinformation- und/oder Preisinformation-Anzeigevorrichtung,
wobei die Anzeigevorrichtung (2) einen Bildschirm (3) und ein Gehäuse bzw. eine Gehäuseschale (6), in dem/der der Bildschirm (3) aufgenommen ist, aufweist, wobei das Gehäuse bzw. die Gehäuseschale (6) an seiner/ihrer den Bildschirm (3) rückseitig umfassenden Gehäuserückseite eine Befestigungsstruktur (7) aufweist, die derart ausgebildet ist, dass die Anzeigevorrichtung (2) an der Regalschiene (1) befestigbar ist,
wobei die Regalschiene (1) aufweist:
ein sich entlang der Regalschiene (1) erstreckendes erstes Klammerelement (15) und ein sich im Wesentlichen parallel dazu erstreckendes zweites Klammerelement (16),
wobei die beiden Klammerelemente (15, 16) zum klammerartigen Zusammenwirken mit der Befestigungsstruktur (17) der Anzeigevorrichtung (2) ausgebildet sind,
wobei zumindest eines der beiden Klammerelemente (15, 16) derart ausgebildet ist, dass es eine Regalschiene-Aussteifungsstruktur (18) bildet, die das Gehäuse bzw. die Gehäuseschale (6) einer bestimmungsgemäß in die Regalschiene (1) eingesetzten Anzeigevorrichtung (2) an ihrer Gehäuserückseite benachbart zu der Befestigungsstruktur (7), insbesondere im Wesentlichen bis hin zum Rand der Gehäuserückseite, aussteift.

2. Regalschiene (1) nach Anspruch 1, wobei zumindest eines der beiden Klammerelemente (15, 16) einen Betätigungsfortsatz (19) aufweist, der so dimensioniert ist, dass er über den Gehäuserand des Gehäuses bzw. der Gehäuseschale (6) einer bestimmungsgemäß in die Regalschiene (1) eingesetzten Anzeigevorrichtung (2) hinausragt, wobei das den Betätigungsfortsatz (19) aufweisende Klammerelement (16) derart ausgebildet ist, dass bei einer Krafteinwirkung auf den Betätigungsfortsatz (19) das klammerartige Zusammenwirken mit der Befestigungsstruktur (7) der Anzeigevorrichtung (2) lösbar ist.

3. Regalschiene (1) nach Anspruch 2, wobei der Betätigungsfortsatz (19) entlang der gesamten Regalschiene (1) ausgebildet ist.

4. Regalschiene (1) nach Anspruch 2 oder 3, wobei der Betätigungsfortsatz (19) an jenem Klammerelement (15, 16) ausgebildet ist, das die längere Regalschiene-Aussteifungsstruktur (18) bildet.

5. Regalschiene (1) nach einem der Ansprüche 2 bis 4, wobei der Betätigungsfortsatz (19) an beiden Klammerelementen (15, 16) ausgebildet ist.

6. Regalschiene (1) nach einem der Ansprüche 1 bis 5, wobei zumindest eines der Klammerelemente (15, 16) ein zum Zusammenwirken mit der Befestigungsstruktur (7) der Anzeigevorrichtung (2) bestimmtes Fixierung-Element (17) zur Fixierung der Position der Anzeigevorrichtung (2) aufweist.

7. Regalschiene (1) nach Anspruch 6, wobei das Fixierung-Element (17) als Kunststoffelement ausgebildet ist.

8. Regalschiene (1) nach Anspruch 7, wobei das Fixierung-Element (17) als auf das Klammerelement (15) extrudierte Kunststoffbahn realisiert ist.

9. Regalschiene (1) nach Anspruch 8, wobei die Kunststoffbahn als Gummibelag ausgebildet ist.

10. Regalschiene (1) nach einem der Ansprüche 6 bis 9, wobei das Fixierungs-Element (17) dazu ausgebildet ist, sicherzustellen, dass bei geklammerter Befestigungsstruktur (7) kein seitliches Verrutschen der Anzeigevorrichtung auftreten kann.

11. Regalschiene (1) nach einem der Ansprüche 6 bis 10, wobei die Position der Anzeigevorrichtung (2) entlang der Regalschiene (1) durch Reibung fixierbar ist, wobei bei gelöster Klammerwirkung eine wahlfreie Positionierung der Anzeigevorrichtung (2) entlang der Regalschiene (1) erhalten bleibt.

12. Regalschiene (1) nach einem der Ansprüche 1 bis 11, wobei zumindest ein Teil der Befestigungsstruktur (7) der Anzeigevorrichtung (2) als Batteriefachabdeckung (9) ausgebildet ist.

13. Regalschiene (1) nach einem der Ansprüche 1 bis 12, wobei die Regalschiene (1) einen Kanal (21) aufweist, der zum Einschnappen bzw. Einlegen eines papier- und/oder kunststoffbasierten Etiketts (22) ausgebildet ist.

14. Regalschiene (1) nach einem der Ansprüche 1 bis 13, wobei das erste Klammerelement (15) und/oder das zweite Klammerelement (16) parallel zur Rückseite der Gehäuseschale (6) verlaufende Abschnitte aufweisen, welche die Regalschiene-Aussteifungsstrukturen (18) bilden und dazu ausgebildet sind, mit der Gehäuseschale (6) in Kontakt zu stehen.

15. System, aufweisend die Regalschiene (1) und die elektronische Anzeigevorrichtung (2) nach einem der Ansprüche 1 bis 14.
